(19) Europäisches Patentamt / European Patent Office / Office européen des brevets

(11) **EP 1 506 582 B1**

(12) **EUROPÄISCHE PATENTSCHRIFT**

(45) Veröffentlichungstag und Bekanntmachung des Hinweises auf die Patenterteilung:
**22.12.2010 Patentblatt 2010/51**

(51) Int Cl.:
**H01L 51/42** (2006.01)

(21) Anmeldenummer: **03726984.2**

(22) Anmeldetag: **06.05.2003**

(86) Internationale Anmeldenummer:
**PCT/AT2003/000131**

(87) Internationale Veröffentlichungsnummer:
**WO 2003/098715 (27.11.2003 Gazette 2003/48)**

(54) **VERFAHREN ZUR NACHBEHANDLUNG EINER PHOTOVOLTAISCHEN ZELLE**

METHOD FOR THE POST-TREATMENT OF A PHOTOVOLTAIC CELL

PROCEDE DE POST-TRAITEMENT D'UNE CELLULE PHOTOVOLTAIQUE

(84) Benannte Vertragsstaaten:
**AT BE BG CH CY CZ DE DK EE ES FI FR GB GR HU IE IT LI LU MC NL PT RO SE SI SK TR**

(30) Priorität: **22.05.2002 AT 7752002**

(43) Veröffentlichungstag der Anmeldung:
**16.02.2005 Patentblatt 2005/07**

(73) Patentinhaber: **Konarka Austria Forschungs-und Entwicklungs GMBH**
**4010 Linz (AT)**

(72) Erfinder:
- **SARICIFTCI, Serdar**
  **A-4040 Linz (AT)**
- **GLÖTZL, Erhard**
  **A-4040 Linz (AT)**
- **DENK, Patrick**
  **A-4020 Linz (AT)**
- **RITTBERGER, Roman**
  **A-4040 Linz (AT)**
- **PADINGER, Franz**
  **4502 St Marien (AT)**

(74) Vertreter: **Peterreins, Frank**
**Fish & Richardson P.C.**
**HighLight Business Towers**
**Mies-van-der-Rohe-Strasse 8**
**80807 München (DE)**

(56) Entgegenhaltungen:
**WO-A-98/35393**

- **PATENT ABSTRACTS OF JAPAN vol. 1998, no. 11, 30. September 1998 (1998-09-30) & JP 10 150234 A (TOSHIBA CORP), 2. Juni 1998 (1998-06-02)**
- **DITTMER J J ET AL: "Crystal network formation in organic solar cells" SOLAR ENERGY MATERIALS AND SOLAR CELLS, ELSEVIER SCIENCE PUBLISHERS, AMSTERDAM, NL, Bd. 61, Nr. 1, 15. Februar 2000 (2000-02-15), Seiten 53-61, XP004244749 ISSN: 0927-0248**
- **MARCHANT S ET AL: "Annealing behaviour of conductive poly(3-hexylthiophene) films" POLYMER, ELSEVIER SCIENCE PUBLISHERS B.V, GB, Bd. 38, Nr. 7, 1997, Seiten 1749-1751, XP004055199 ISSN: 0032-3861**
- **SENTEIN C ET AL: "Study of orientation induced molecular rectification in polymer films" OPTICAL MATERIALS, ELSEVIER SCIENCE PUBLISHERS B.V. AMSTERDAM, NL, Bd. 9, Nr. 1-4, 1998, Seiten 316-322, XP004123046 ISSN: 0925-3467**

## Beschreibung

Technisches Gebiet

Die Erfindung bezieht sich auf ein Verfahren zur Nachbehandlung einer photovoltaischen Zelle mit einer photoaktiven Schicht aus zwei molekularen Komponenten, nämlich einem Elektronendonator und einem Elektronenakzeptor, insbesondere einer konjugierten Polymerkomponente und einer Fullerenkomponente, und mit zwei beidseits der photoaktiven Schicht vorgesehenen, Elektroden, wobei die photovoltaische Zelle einer Wärmebehandlung über der Glasumwandlungstemperatur des Elektronendonators während einer vorgegebenen Behandlungszeitspanne unterworfen wird.

Stand der Technik

Als konjugierte Kunststoffe bezeichnete Kunststoffe mit einer abwechselnden Aufeinanderfolge von Einfach- und Doppelbindungen weisen hinsichtlich der Elektronenenergie mit Halbleitern vergleichbare Energiebänder auf, so daß sie auch durch ein Dotieren vom nichtleitenden, in den metallisch leitenden Zustand überführt werden können. Beispiele für solche konjugierten Kunststoffe sind Polyphenylene, Polyvinylphenylene, Polythiophene oder Polyaniline. Der Wirkungsgrad der Energieumwandlung von photovoltaischen Polymerzellen aus einem konjugierten Polymer liegt allerdings typischerweise zwischen $10^{-3}$ und $10^{-2}$ %. Zur Verbesserung dieses Wirkungsgrades ist es bekannt (US 5 454 880 A), die photoaktive Schicht aus zwei molekularen Komponenten auszubauen, von denen die eine durch ein konjugiertes Polymer als Elektronendonator und die andere durch ein Fulleren, insbesondere ein Buckminsterfulleren $C_{60}$, als Elektronenakzeptor gebildet werden. Die an den Grenzflächen zwischen diesen Komponenten durch Licht induzierte, sehr schnelle Elektronenbewegung verhindert eine weitergehende Ladungsträgerrekombination, was eine entsprechende rekombination, was eine entsprechende Ladungstrennung zur Folge hat. Diese wirksame Ladungstrennung findet allerdings nur im Grenzflächenbereich zwischen dem Elektronendonator und dem Elektronenakzeptor statt, so daß eine möglichst homogene Verteilung der als Elektronenakzeptor wirksamen Fullerenkomponente in der den Elektronendonator bildenden Polymerkomponente angestrebt wird.

Da gezeigt werden konnte, daß sich die Elektronenbeweglichkeit in einer kristallinen Polymermatrix im Vergleich zu einer amorphen Matrix vergrößert, und bei einer Temperatur über der Glasumwandlungstemperatur die Kristallbildung zunimmt, wurde bereits vorgeschlagen, die photovoltaischen Zellen einer Nachbehandlung durch Wärme zu unterwerfen, um den Wirkungsgrad steigern zu können. Dabei wurden die photovoltaischen Zellen einer Behandlungstemperatur von 60 bis 150 °C während einer Behandlungszeitspanne von 1 h ausgesetzt, wobei sich eine obere Grenze für den Wirkungsgrad von ca. 3 % ergab, die durch eine Optimierung der Wärmebehandlung nicht mehr angehoben werden konnte.

Darstellung der Erfindung

Der Erfindung liegt somit die Aufgabe zugrunde, ein Verfahren zur Nachbehandlung einer photovoltaischen Zelle der eingangs geschilderten Art, so auszugestalten, daß eine weitere Steigerung des Wirkungsgrades möglich wird.

Die Erfindung löst die gestellte Aufgabe dadurch, daß die Wärmebehandlung der photovoltaischen Zelle zumindest während eines Abschnittes der Behandlungszeitspanne unter dem Einfluß eines elektrischen Feldes durchgeführt wird, das durch eine an die Elektroden der photovoltaischen Zelle angelegte, deren Leerlaufspannung übersteigende Erregerspannung erregt wird.

Durch den Einfluß des während der Wärmebehandlung über die Elektroden der photovoltaischen Zelle erregten elektrischen Feldes kann der Wirkungsgrad der photovottaischen Zelle in überraschender Weise gesteigert werden. Eine mögliche Erklärung für diese Wirkungsgradverbesserung wird darin gesehen, daß durch das elektrische Feld zusätzliche Ladungsträger über die Elektroden in die photoaktive Schicht injiziert werden. Diese zusätzlichen Ladungsträger unterstützen die Ausrichtung der Polymerkomponente in Richtung des angelegten elektrischen Feldes, was eine entsprechende Beweglichkeit der Polymermoleküle voraussetzt, die durch die Erwärmung der photovoltaischen Zelle über die Glasumwandlungstemperatur der Polymerkomponente sichergestellt wird. Mit der verstärkten Ausrichtung des Polymers erhöht sich dessen Leitfähigkeit für Ladungsträger. Außerdem werden die elektrischen Kontakte zwischen den Elektroden und der photoaktiven Schicht nachhaltig verbessert, so daß der serielle Widerstand innerhalb der photovoltaischen Zelle verringert wird. Mit dieser Verringerung des seriellen Widerstandes geht außerdem eine Vergrößerung des Kurzschlußstromes und des Füllfaktors einher.

Damit in der photoaktiven Polymerkomponente über das elektrische Feld Ladungsträger injiziert werden können, muß die zur Erregung des elektrischen Feldes an die Elektroden der photovoltaischen Zelle angelegte Erregerspannung die Leerlaufspannung der photovoltaischen Zelle entsprechend übersteigen. Um eine gute Wirkung zu erzielen, soll die Erregerspannung die Leerlaufspannung um wenigstens 1 V übersteigen. Besonders günstige Verhältnisse ergeben sich für die meisten Anwendungsfälle, wenn die Erregerspannung zwischen 2,5 und 3 V gewählt wird. Die Obergrenze der Erregerspannung wird an sich durch die Belastbarkeit der photovoltaischen Zelle durch das angelegte elektrische Feld begrenzt. Eine Erhöhung der Erregerspannung über den angegebenen Bereich von 2,5 bis 3 V bringt allerdings im allgemeinen keine Steigerung der Richtwirkung auf die photoaktive Polymerkomponente mit sich.

Der positive Einfluß der Wärmebehandlung auf die Kristallisationsneigung der photoaktiven Polymerkomponente nimmt nach einer bestimmten Behandlungszeitspanne ab, so daß die Zeitspanne, während der die photovoltaische Zelle unter Einfluß eines elektrischen Feldes einer Wärmebehandlung unterworfen wird, vorteilhaft beschränkt wird. Behandlungszeitspannen zwischen 2 und 8 min ergeben günstige Voraussetzungen für die Wärmebehandlung, wobei sich ein Optimum im Bereich einer Behandlungszeitspanne zwischen 4 und 5 min einstellt.

Kurze Beschreibung der Zeichnung

Anhand der Zeichnung wird das erfindungsgemäße Verfahren zur Nachbehandlung einer photovoltaischen Zelle näher erläutert. Es zeigen

Fig. 1    eine einer Nachbehandlung zu unterwerfende photovoltaische Zelle in ei- nem schematischen Schnitt,

Fig. 2    Kennlinien, die den Zusammenhang zwischen der Spannung und der Stromdichte für photovoltaische Zellen grundsätzlich gleichen Aufbaus, je- doch ohne Wärmebehandlung, mit Wärmebehandlung und mit Wärmebe- handlung unter Einfluß eines elektrischen Feldes wiedergeben,

Fig. 3    die auf die Wellenlänge der Photoanregung bezogene Ladungsausbeute je einfallender Lichtleistung wieder für in ihrem Aufbau übereinstimmende photovoltaische Zellen ohne und mit Wärmebehandlung sowie einer Wärmebehandlung unter Einfluß eines elektrischen Feldes und

Fig. 4    die Abhängigkeit des erzielbaren Wirkungsgrades von photovoltaischen Zellen von der Dauer der Wärmebehandlung mit und ohne Einfluß eines elektrischen Feldes.

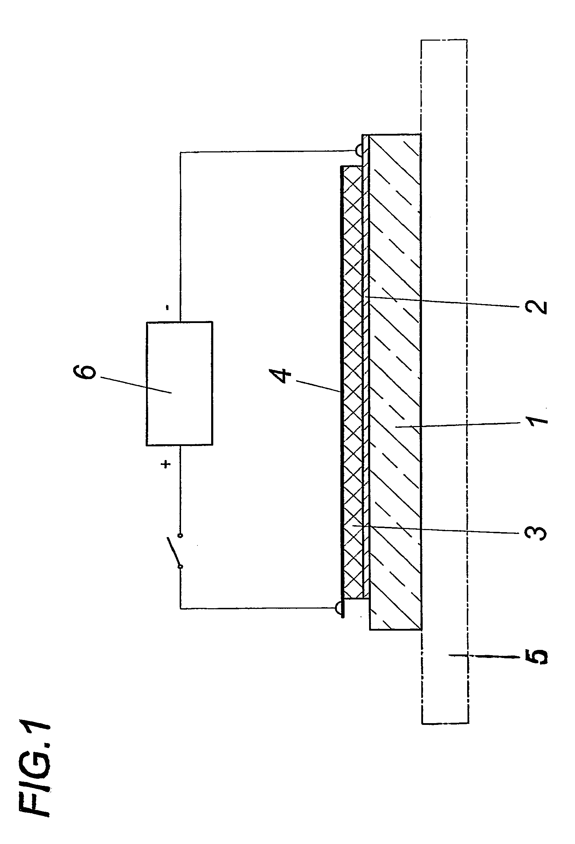

Gemäß der Fig. 1 besteht die photovoltaische Zelle aus einem lichtdurchlässigen Glasträger 1, der mit einer Elektrode 2 aus einem Indium-Zinn-Oxid (ITO) beschichtet ist. Auf dieser Elektrode 2, die im allgemeinen mit einer Glättungsschicht aus einem durch eine Dotierung elektrisch leitfähig gemachten Polymer, üblicherweise Polyäthylendioxythiophen (PEDOT) abgedeckt wird, ist eine photoaktive Schicht 3 aus zwei molekularen Komponenten, nämlich einer konjugierten Polymerkomponente und einer Fullerenkomponente aufgetragen. Die photoaktive Schicht 3 trägt dann die Gegenelektrode 4, die bei der Verwendung von ITO als lochsammelnde Elektrode 2 aus einer Aluminiumschicht zur Bildung einer elektronensammelnden Elektrode besteht

Im Falle des Ausführungsbeispiels wurde als Polymerkomponente ein Polythiophen eingesetzt, das ausgeprägte Kristallisationseigenschaften als Voraussetzung für eine gute Lochleitfähigkeit mit sich bringt. Als Polythiophen wurde dabei ein Poly-3-hexylthiophen (P3HT) mit einem Methanofulleren, nämlich [6.6]-Phenyl-$C_{61}$-butylsäuremethylester (PCBM), als Elektronenakzeptor verwendet. Auf die ITO-Elektrode 2, die eine Schichtstärke von 125 nm aufwies, wurde eine Schicht aus Polyäthylendioxythiophen-Polystyrolsulfonat (PEDOT-PSS) in einer Dicke von ca. 50 nm aufgebracht, bevor nach einer Trocknungszeit von ca. 45 min unter einem Vakuum von $10^{-1}$ bis $10^{-2}$ mbar die photoaktive Schicht aufgetragen wurde, und zwar in Form einer Lösung aus 10 mg P3HT und 20 mg PCBM je ml Lösungsmittel. Als Lösungsmittel wurde 1.2-Dichlorbenzol eingesetzt. Nach einer Trocknungszeit von ca. 45 min unter einem Vakuum von $10^{-1}$ bis $10^{-2}$ mbar wurde zunächst eine Schicht von 0,6 nm Lithiumfluorid und danach die Aluminiumelektrode in einer Schichtdicke von 70 nm im selben Hochvakuumschritt ($10^{-6}$ mbar) aufgedampft.

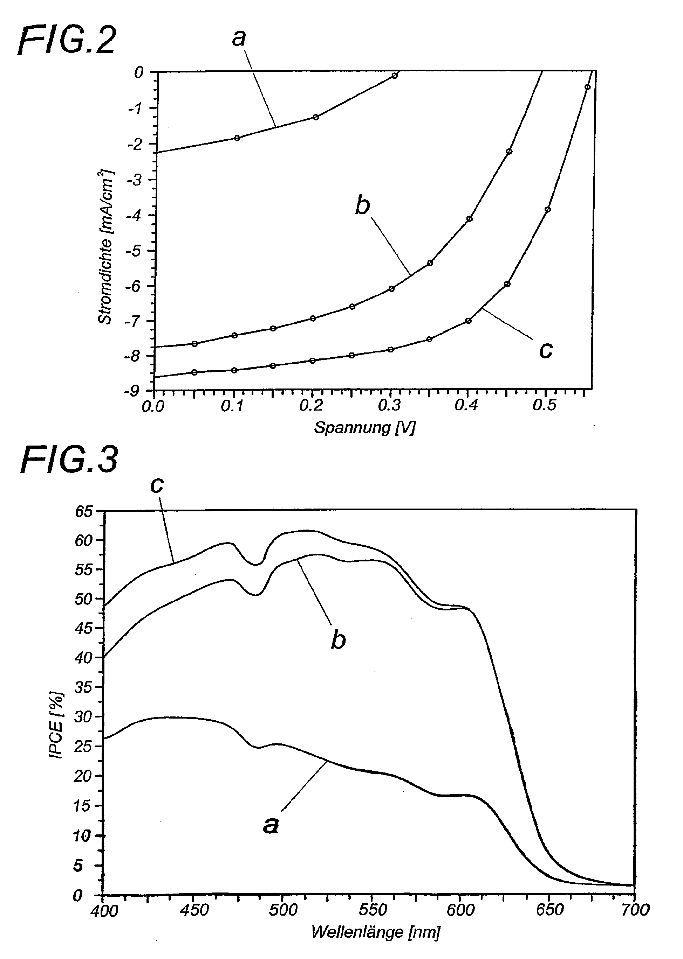

Die in dieser Weise hergestellten photovoltaischen Zellen wurden einer Nachbehandlung durch Wärme unterzogen, und zwar in Verbindung mit einem elektrischen Feld. Zu diesem Zweck wurden die photovoltaischen Zellen auf eine Heizplatte 5 gesetzt, wobei die Elektroden 2 und 4 an eine elektrische Spannungsquelle 6 angeschlossen wurden. Zwischen den mit 2,7 V beaufschlagten Elektroden 2 und 4 wurde die photoaktive Schicht 3 dem Einfluß eines durch diese Erregerspannung erregten elektrischen Feldes ausgesetzt, sobald die photoaktive Schicht 3 auf eine Behandlungstemperatur zwischen 70 und 75 °C erwärmt wurde, also einer Temperatur über der Glasumwandlungstemperatur der Polymerkomponente. Nach einer Behandlungszeitspanne von 4 min wurde die Nachbehandlung abgebrochen. Die photovoltaischen Zellen kühlten auf Raumtemperatur ab. Zur Veranschaulichung der mit der Erwärmung und der gleichzeitigen Erregung eines elektrischen Feldes erzielbaren Wirkungen wurden die in den Fig. 2 und 3 dargestellten Kennlinien für gleich aufgebaute photovoltaische Zellen gemessen, die einerseits ohne Nachbehandlung blieben und anderseits einer Wärmebehandlung ohne und mit Einfluß eines elektrischen Feldes gemäß den oben angegebenen Bedingungen ausgesetzt wurden.

Die Kennlinien gemäß der Fig. 2 wurden bei einer Belichtung mit weißem Licht (80mW/cm$^2$) aufgenommen. Die für eine photovoltaische Zelle ohne Nachbehandlung aufgenommene Kennlinie a zeigt eine Leerlaufspannung von 300 mV und eine Stromdichte für den Kurzschlußstrom von ca. 2,5 mA/cm$^2$ bei einem Füllfaktor von 0,4. Der Wirkungsgrad kann für diese photovoltaischen Zellen mit ca. 0,4 % angegeben werden. Die Kennlinie b wurde für eine photovoltaische Zelle aufgenommen, die einer Nachbehandlung nur durch Wärme unterworfen wurde. Im Vergleich zur Kennlinie a steigen die Leerlaufspannung auf 500 mV und die Dichte des Kurzschlußstromes auf ca. 7,5 mA/cm$^2$. Der Füllfaktor wurde mit 0,57 ermittelt. Der Wirkungsgrad liegt bei diesen photovoltaischen Zellen bei 2,5 %. Für photovoltaische Zellen, die einer Wärmebehandlung unter dem Einfluß eines elektrischen Feldes unterworfen wurden, gibt die Kennlinie c eine Leerlaufspannung von ca. 550 mV und eine Kurzschlußstromdichte von ca. 8,5 mA/cm² an. Bei einem Füllfaktor von 0,6 ergibt sich eine Steigerung des Wirkungsgrades auf 3,5 %.

In der Fig. 3 kann die Ladungsausbeute je einfallender Lichtleistung

$$IPCE\ [\%] = 1240.I_k\ /\ \lambda.I_l$$

über der in nm gemessenen Wellenlänge λ für die zu vergleichenden photovoltaischen Zellen abgelesen werden. Mit $I_k$ ist die in μA/cm² gemessene Dichte des Kurzschlußstroms und mit $I_1$ die in W/m² gemessene Lichtleistung in die obige Formel einzutragen. Es zeigt sich, daß die Quanteneffizienz IPCE für photovoltaische Zellen ohne Nachbehandlung ein Maximum von etwa 30% bei einer Wellenlänge von 440 nm erreicht, wie dies der Kennlinie a entnommen werden kann. Mit einer Wärmebehandlung ohne Einfluß eines elektrischen Feldes erhöht sich die Quanteneffizienz IPCE beinahe um das Doppelte bei gleichzeitiger Verschiebung zu einem Bereich höherer Wellenlängen, so daß diese Wellenlängenbereiche der solaren Strahlung besser genutzt werden können. Durch die Nachbehandlung mit Wärme unter Einfluß des elektrischen Feldes kann eine weitere Steigung entsprechend der Kennlinie c gewährleistet werden, was eine Quanteneffizienz IPCE von 61 % ergibt.

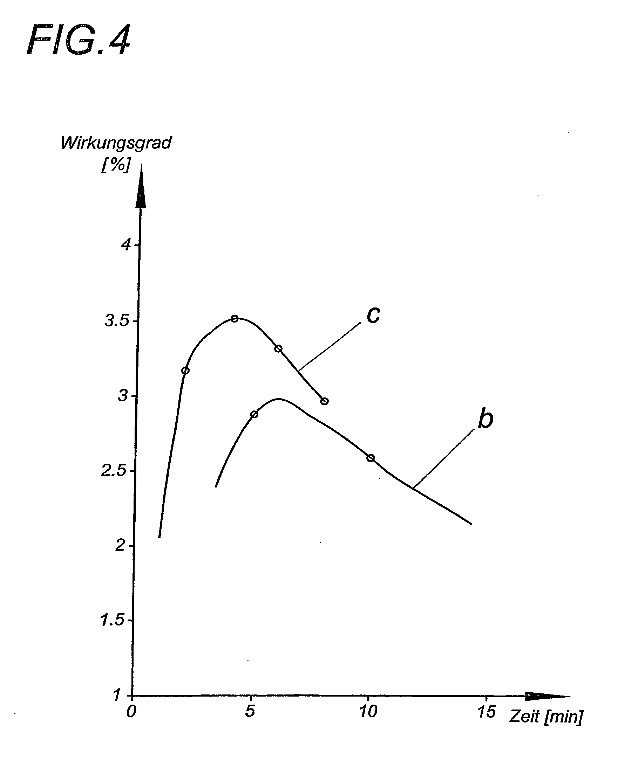

In der Fig. 4 ist der Wirkungsgrad von photovoltaischen Zellen bei einer Warmebehandlung mit und ohne Einfluß eines elektrischen Feldes in Abhängigkeit von der Behandlungszeit dargestellt. Es läßt sich unmittelbar ablesen, daß sich der Wirkungsgrad mit der Behandlungszeit ändert. Für photovoltaische Zellen mit einer Wärmebehandlung ohne Einfluß eines elektrischen Feldes wird ein Maximum des Wirkungsgrades bei einer Behandlungszeit im Bereich von 6 min erreicht. Unter der Einwirkung eines elektrischen Feldes ergeben sich für das Wirkungsgradmaximum kürzere Behandlungszeiten in der Größenordnung von etwa 4 min.

**Patentansprüche**

1. Verfahren zur Nachbehandlung einer photovoltaischen Zelle mit einer photoaktiven Schicht (3) aus zwei molekularen Komponenten, und mit zwei beidseits der photoaktiven Schicht (3) vorgesehenen, Elektroden (2,4), wobei eine Wärmebehandlung der photovoltaischen Zelle zumindest während eines Abschnittes einer Behandlungszeitspanne unter dem Einfluß eines elektrischen Feldes durchgeführt wird, das durch eine an die Elektroden der photovoltaischen Zelle angelegte, deren Leerlaufspannung übersteigende Erregerspannung erregt wird, **dadurch gekennzeichnet, dass** die zwei molekularen Komponeneten ein Elektronendonator und ein Elektronenakzeptor sind, und dass die photovoltaische Zelle einer Wärmebehandlung über der Glasumwandlungstemperatur des Elektronendonators während der vorgegebenen Behandlungszeitspanne unterworfen wird.

2. Verfahren nach Anspruch 1, **dadurch gekennzeichnet, daß** das elektrische Feld mit einer die Leerlaufspannung der photovoltaischen Zelle um wenigstens IV übersteigende Erregerspannung erregt wird.

3. Verfahren nach Anspruch 2, **dadurch gekennzeichnet, daß** die Erregerspannung zwischen 2,5 und 3V gewählt wird.

4. Verfahren nach einem der Ansprüche 1 bis 3, **dadurch gekennzeichnet, daß** die photovoltaische Zelle während einer Behandlungszeitspanne zwischen 2 und 8 min, vorzugsweise zwischen 4 und 5 min, einer Wärmebehandlung unter Einfluß eines elektrischen Feldes ausgesetzt wird.

5. Verfahren nach einem der Ansprüche 1 bis 4, **dadurch gekennzeichnet, dass** für den Elektronendonator und den Elektronen akzeptor eine konjugierte Polymer komponente und eine Fullerenkomponente verwendet werden.

**Claims**

1. Method for post treatment of a photovoltaic cell having a photoactive layer (3) of two molecular components, and with two designated electrodes (2, 4) on both sides of the photoactive layer (3), wherein a heat treatment of the photovoltaic cell is carried out at least during a fraction of time of a treatment span of time under the influence of an electric field which is excited by an excitation voltage applied to the electrodes of the photovoltaic cell, and exceeding its open circuit voltage, **characterized in that** the two molecular components are an electron donor and an electron acceptor, and that the photovoltaic cell is subject to a heat treatment above the glass transition temperature of the electron donor during the predetermined treatment span of time.

2. Method of claim 1, **characterized in that** the electric field is excited with an excitation voltage that exceeds the open circuit voltage of the photovoltaic cell by at least IV.

3. Method of claim 2, **characterized in that** the excitation voltage is selected between 2.5 and 3V.

**4.** Method of anyone of claims 1 to 3, **characterized in that** the photovoltaic cell during a treatment span of time between 2 and 8 minutes, preferably between 4 and 5 minutes, is subject to a heat treatment under the influence of an electric field.

**5.** Method of anyone of claims 1 to 4, **characterized in that** for the electron donor and the electron acceptor a conjugated polymer component and a fullerene component are used.

**Revendications**

**1.** Procédé pour le post-traitement d'une cellule photovoltaïque comportant une couche photoactive (3) formée de deux composants moléculaires, et comportant deux électrodes (2, 4) prévues des deux côtés de la couche photoactive (3), dans lequel on exécute un traitement thermique de la cellule photovoltaïque au moins pendant une portion d'une durée de traitement sous l'influence d'un champ électrique qui est excité par une tension d'excitation appliquée aux électrodes de la cellule photovoltaïque et dépassant sa tension à vide,
**caractérisé en ce que** les deux composants moléculaires sont un donateur d'électrons et un accepteur d'électrons, et **en ce que** la cellule photovoltaïque est soumise à un traitement thermique au-dessus de la température de transition vitreuse du donateur d'électrons pendant la durée de traitement prédéterminée.

**2.** Procédé selon la revendication 1, **caractérisé en ce que** le champ électrique est excité avec une tension d'excitation qui dépasse la tension à vide de la cellule photovoltaïque d'au moins 1 V.

**3.** Procédé selon la revendication 2, **caractérisé en ce que** la tension d'excitation est choisie entre 2,5 et 3 V.

**4.** Procédé selon l'une des revendications 1 à 3, **caractérisé en ce que** la cellule photovoltaïque est exposée à un traitement thermique sous l'influence d'un champ électrique pendant une durée de traitement entre 2 et 8 minutes, de préférence entre 4 et 5 minutes.

**5.** Procédé selon l'une des revendications 1 à 4, **caractérisé en ce que** l'on utilise une composante polymére conjuguée et une composante fulleréne pour le donateur d'électrons et pour l'accepteur d'électrons.

FIG.1

EP 1 506 582 B1

## FIG.2

## FIG.3

# FIG.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5454880 A